# EUROPÄISCHE PATENTSCHRIFT

(11) **EP 0 667 024 B1**
(45) Veröffentlichungstag und Bekanntmachung des Hinweises auf die Patenterteilung: **09.12.1998**
(21) Anmeldenummer: 94924717.5
(22) Anmeldetag: 06.07.1994
(51) Int. Cl.: G11B 7/26, G11B 7/00

(54) **CD-MASTERINGVERFAHREN**
CD MASTERING PROCESS
PROCEDE DE PRODUCTION DE MATRICES POUR DISQUES COMPACTS

(30) Priorität: 02.09.1993 DE 4329712
(43) Veröffentlichungstag der Anmeldung: 16.08.1995
(73) Patentinhaber: SONOPRESS PRODUKTIONSGESELLSCHAFT FÜR TON- UND INFORMATIONSTRÄGER mbH, D-33332 Gütersloh (DE)
(72) Erfinder: SCHIEWE, Hilmar, D-33332 Gütersloh (DE)
(74) Vertreter: Prietsch, Reiner, Dipl.-Ing.
(86) Internationale Anmeldenummer: EP9402209
(87) Internationale Veröffentlichungsnummer: WO9506943

(56) Entgegenhaltungen:
- EP-A- 0 081 649
- DE-A- 3 504 969
- JP-A- 5 135 412
- US-A- 4 896 313
- PATENT ABSTRACTS OF JAPAN vol. 13, no. 430 (P-937) 26. September 1989 & JP,A,01 162 254 (SANYO ELECTRIC CO) 26. Juni 1989

## Beschreibung

Die Erfindung betrifft ein Verfahren zum Herstellen eines für die Replizierung von optischen Speichermedien des CD-Typs verwendbaren, einen planen Träger und eine Photolackschicht umfassenden Masters, in dessen Photolackschicht spurenweise angeordnete Vertiefungen, die sogenannten Pits, erzeugt werden, deren in Spurrichtung gemessene Länge und deren gegenseitiger Abstand, die sogenannten Lands, binär kodierte Daten repräsentieren. Dieses allgemein bekannte Verfahren umfaßt u.a. folgende Schritte:
- Die Photolackschicht wird spurenweise mit einem Laserstrahl belichtet, der durch die H-Pegel eines Steuersignals ein- und durch dessen L-Pegel ausgeschaltet wird; das Steuersignal ist das elektrische Abbild eines die zu speichernden Daten beinhaltenden, seriellen, binären Datenstroms.
- Der Träger wird entwickelt, bis die Photolackschicht an den belichteten Stellen Vertiefungen aufweist.
- Das Entwickeln wird beendet, sobald die den H-Pegeln des Steuersignals entsprechenden Vertiefungen ein gemitteltes Volumen erreicht haben, das gleich einem vorgegebenen Wert ist.

Dieses Verfahren ist seit langem bei der CD-Herstellung üblich. Ein praktisch identisches Verfahren ist auch aus der EP-A 0 081 649 bekannt, allerdings zur Herstellung eines Masters für die Replizierung von optischen Speichermedien des Videodisc- oder Bildplatten-Typs. Der Unterschied besteht nur darin, daß im letzteren Fall auf dem Master Pits und Lands aufgezeichnet werden, von denen jedes eine Halbwelle des frequenzmodulieren Videosignals repräsentiert.

Bei dem eingangs genannten, bei der CD-Herstellung üblichen Verfahren wird das gewöhnlich als MTF-Signal bezeichnete Steuersignal von einem Enkoder geliefert und einem Laserbeamrecorder zugeführt. Der Enkoder setzt die zu speichernden Daten, z.B. ein PCM-kodiertes Audiosignal, gemäß dem Cross-Interleave-Reed-Solomon-Code mit anschließender Eight-to-Fourteen-Modulation sowie unter Hinzufügung von Kontroll- und Synchronisationsbits in das MTF-Signal um, das eine sogenannte Channelbitfrequenz von einigen Megahertz, derzeit 4,3218 MHz, hat und lediglich neun diskrete Werte der Impulsdauer und der Impulspause aufweist, die dementsprechend zur Erzeugung von neun unterschiedlichen Pit- bzw. Landlängen auf dem Master führen. Da die Pits und die Lands gleichwertig sind und als logischer Wert Null definiert sind, während die Übergänge von Pit zu Land bzw. von Land zu Pit die logische Eins darstellen, und da im Rahmen des Mastering die Erzeugung und Formgebung der Pits der entscheidende Schritt ist, sind die nachfolgenden Angaben auf die Pits abgestellt. Die neun Pits unterschiedlicher Dauer und dementsprechend unterschiedlicher Länge werden als I3- bis I11-Pits bezeichnet. Aus der oben angegebenen Channelbitfrequenz errechnet sich als Kehrwert der Bittakt zu 231,39 ns und damit die Dauer der I3-Pits zu 3 x 231,39 ns = 694 ns, sowie die Dauer der I11-Pits zu 11 x 231,39 ns = 2545 ns.

Um die Channelbitfrequenz konstant zu halten, wird während des von innen nach außen erfolgenden Belichtens des Masters dessen Drehzahl entsprechend nachgeregelt. Bei den heute üblichen Speichermedien des CD-Typs mit einer Spurlesegeschwindigkeit entweder von 1,2 m/s oder von 1,4 m/s ändert sich deshalb die Drehzahl zwischen dem kleinsten und dem größten belichteten Radius des Masters entweder von 486 auf 196 U/min (für 1,2 m/s) oder von 568 auf 228 U/min (für 1,4 m/s). Mit den oben angegebenen Zeitdauern errechnet sich für die kleinere Spurlesegeschwindigkeit die kleinste Länge eines I3-Pits mit 0,833 µm und für die größere Spurlesegeschwindigkeit die größte Länge eines I11-Pits mit 3,563 µm.

Das komplexe Kodierverfahren, dessen Ergebnis das MTF-Signal ist, sorgt u.a. dafür, daß dieses MTF-Signal gleichwertfrei ist, also sein zeitlicher Mittelwert (wechselstrommäßig betrachtet) gleich Null ist. Damit das von dem entsprechenden optischen Speichermedium bei dessen Auslesen erzeugte MTF-Signal die gleiche Bedingung erfüllt, müssen auf dem aus dem belichteten Master über mehrere, bekannte Zwischenschritte erzeugten optischen Speichermedium die I3- bis I11-Pits jeweils die gleiche geometrische Länge wie die ihnen entsprechenden I3- bis I11-Lands haben. Um dies zu erreichen, ist es notwendig, den Entwicklungsprozess genau zu kontrollieren und dann zu beenden (abzubrechen), wenn die Pits eine Länge erreicht haben, bei der für das fertige Speichermedium erfahrungsgemäß die vorgenannte Symmetriebedingung erfüllt ist, die kurz als Symmetrie = 0 bezeichnet wird. Da die Länge der Pits nicht direkt gemessen werden kann, wird stattdessen während des Entwickelns ein bestimmter Bereich des Masters beleuchtet und in dem reflektierten Beugungsmuster die Intensität des Maximums der nullten Ordnung mit derjenigen des Maximums der ersten Ordnung verglichen, was im Ergebnis einer Messung des gemittelten Volumens der Pits in dem beleuchteten Bereich des Masters entspricht. Wenn das gemessene Verhältnis einen voreingestellten Wert erreicht hat, wird die Entwicklung abgebrochen.

Der Entwicklungsprozeß und die Abmessungen der hierbei entstehenden Pits hängen von zahlreichen Parametern ab, z.B. von den elektrischen und optischen Toleranzen des Laserbeamrecorders, von der Zusammensetzung und der Schichtdicke der Photolackschicht und von der Nachbehandlung des Masters. Erfordern nun diese Parameter eine relativ lange Entwicklungszeit, bis die Symmetriebedingung erfüllt ist, so sind die erzeugten Pits relativ breit und haben steile Flanken. Umgekehrt führt eine kurze Entwicklungszeit zu schmalen Pits mit flachen Flanken. Dieser Zusammenhang ist bekannt, vgl. die DE-C2-29 35 789. Durch Änderung der numerischen Apertur des belichtenden Laserstrahls kann nun zwar die Pitbreite (und gleichzeitig in einem sehr geringen Maße auch die Pitlänge) beeinflußt werden, da eine große numerische Apertur zu einer geringen Pitbreite führt, und umgekehrt. Es besteht jedoch keine Möglichkeit, auf die Flankensteilheit der Pits gezielt Einfluß zu nehmen. Dabei gilt, daß steile Flanken beim Auslesen des von einem derartigen Master replizierten Speichermediums zu besser detektierbaren und zeitlich exakter positionierten Null/EinsÜbergängen und damit zu einer niedrigeren Blockfehlerrate sowie einem geringeren Datenjitern führen, während flache Flanken die Abformbarkeit verbessern und eventuell beim Auslesen auch die Spurverfolgung erleichtern.

Der Erfindung liegt zum ersten die Aufgabe zugrunde, das vorstehend geschilderte, bekannte Verfahren so abzuwandeln, daß die von dem Master replizierten Speichermedien zumindest eine gewisse Anzahl von Pits und Lands haben, die die Bedingung Symmetrie = 0 nicht erfüllen sondern entweder zu kurze Pits und dementsprechend zu lange Lands (positive Symmetrie) oder zu lange Pits und dementsprechend zu kurze Lands (negative Symmetrie) aufweisen.

Diese Aufgabe ist erfindungsgemäß dadurch gelöst, daß das Verhältnis V der Dauer der H-Pegel zu der Dauer der L-Pegel des Steuersignals zumindest zeitweise von dem Wert 1,0 verschieden gemacht wird. Dabei wird die Dauer der H-Pegel und diejenige der L-Pegel jedoch nicht um einen konstanten Faktor geändert sondern um einen absoluten Betrag verkürzt oder verlängert. Beträgt diese Verkürzung oder Verlängerung beispielsweise 100 ns, so ergibt sich hieraus für die I3-Pits und die I3-Lands ein Symmetrieverhältnis von 0,85 bzw. 1,15, hingegen für die I11-Pits und die I11-Lands ein Symmetrieverhältnis von 0,96 bzw. 1,04 (mit entsprechenden Zwischenwerten für die übrigen Pit- bzw. Landlängen). Ein derartiges Speichermedium eignet sich sehr gut zur Prüfung bestimmter Eigenschaften von Lese- und/oder Meßsystemen für Speichermedien des CD-Typs.

Das genannte Verhältnis V liegt vorzugsweise in einem Bereich, dessen unterer Grenzwert einer Verkürzung der Dauer aller H-Pegel um die Dauer des die kürzesten Pits erzeugenden H-Pegels entspricht und dessen oberer Grenzwert einer Verlängerung der Dauer aller H-Pegel um die gleiche Dauer entspricht. Dies bedeutet, daß bei dem unteren Grenzwert die I3-Pits verschwinden während bei dem oberen Grenzwert die I3-Lands verschwinden.

Das Verhältnis V kann auch während des Belichtens der Photolackschicht entsprechend den Abtastwerten eines Informationssignales geändert werden. Durch entsprechende Signalverarbeitung beim Auslesen eines von einem so beschriebenen Master replizierten Speichermediums kann das das Verhältnis V modulierende Informationssignal zurückgewonnen werden. Hierzu ist zwar eine spezielles Auslesegerät notwendig, jedoch kann das Verhältnis V in einem Zeitbereich oder örtlich auf dem Speichermedium so variiert werden, daß hierdurch die Auslesbarkeit des Speichermediums mittels eines normalen Lesegerätes, z.B. eines handelsüblichen CD-Spielers, nicht beeinträchtigt wird. Das das Verhältnis V modulierende Informationssignal kann z.B. eine Herstellerkennzeichnung umfassen und stellt dann ein von Produktpiraten nur schwer nachahmbares Merkmal originaler Speichermedien dar.

Besonders einfach ist diese Modulation des Verhältnisses V dann, wenn das Informationssignal ein binär kodiertes Signal ist.

Insgesamt ermöglicht die vorgeschlagene Abwandlung des bekannten Verfahrens, die Symmetrie der Pits und Lands des replizierten Speichermediums in sehr weiten Grenzen gezielt zu verändern, ohne daß dadurch die Pitbreite und/oder die Flankensteilheit der Pits verändert wird.

Aufbauend auf diesem Vorschlag liegt der Erfindung die weitere Aufgabe zugrunde, das bekannte Verfahren dahingehend zu verbessern, daß die Breite und/oder die Flankensteilheit der Pits unabhängig voneinander und vor allem unabhängig von der Pitlänge verändert werden können. Dabei wird von dem Regelfall ausgegangen, daß die I3- bis I11-Pits fest vorgegebene Längen haben, nämlich solche, die bei den replizierten Speichermedien die Bedingung Symmetrie = 0 erfüllen.

Diese weitere Aufgabe ist erfindungsgemäß dadurch gelöst, daß das Verhältnis V der Dauer der H-Pegel zu der Dauer der L-Pegel des Steuersignals kleiner als 1,0 gemacht wird, und daß die Entwicklungszeit um einen solchen Betrag verlängert wird, daß die mittlere Länge der Vertiefungen in dem replizierten Speichermedium wieder gleich der mittleren Länge deren gegenseitiger Abstände ist.

Mit diesem Verfahren ist es möglich, die Flankensteilheit und die Pitbreite zu erhöhen ohne die Symmetriebedingung zu verletzen, wenn das bekannte Verfahren zu schmale Pits mit zu geringer Flankesteilheit ergibt, denn die Verlängerung der Entwicklungszeit führt zu Pits mit steileren Flanken und größerer Breite.

Sofern jedoch die nach den üblichen Verfahren erzeugten Pits die einem vorgegebenen Sollwert entsprechende Breite haben und lediglich ihre Flankensteilheit zu gering ist, kann eine dann unerwünschte Verbreiterung der Pits bei dem vorgeschlagenen Verfahren dadurch verhindert werden, daß die numerische Apertur des Laserstrahls auf einen Wert vergrößert wird, bei dem die Breite der Pits im Zeitpunkt des Abbruches des Entwicklungsprozesses den vorgegebenen Sollwert nicht überschreitet.

Führt das bekannte Verfahren umgekehrt zu Pits mit zu großer Flankensteilheit und/oder zu großer Breite, so lassen sich diese beiden Parameter gemeinsam oder unabhängig voneinander auf die gewünschten Werte vermindern.

Dies geschieht dadurch, daß das Verhältnis V der Dauer der H-Pegel zu der Dauer der L-Pegel des Steuersignals größer als 1,0 gemacht wird und daß die Entwicklungszeit um einen solchen Betrag verkürzt wird, daß die mittlere Länge der Vertiefungen in dem replizierten Speichermedium wieder gleich der mittleren Länge deren gegenseitiger Abstände ist.

Gegebenenfalls wird dann noch die numerische Apertur des Laserstrahls auf einen Wert verkleinert, bei dem die Pitbreite einen vorgegebenen Sollwert nicht unterschreitet.

Zur weiteren Erläuterung des vorgeschlagenen Verfahrens wird auf die Zeichnung Bezug genommen.

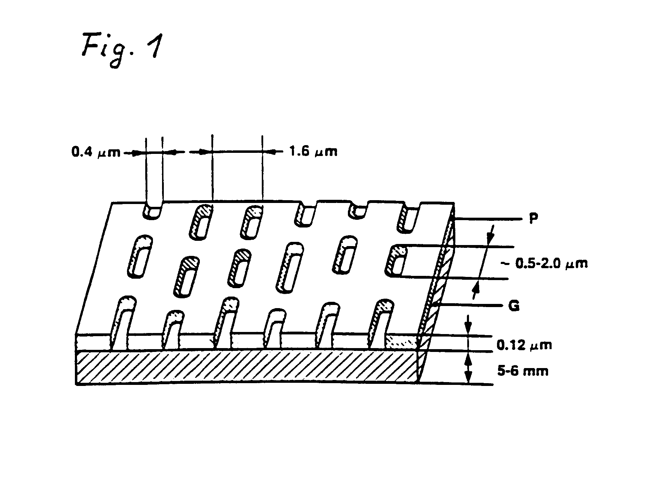

Figur 1 zeigt in perspektivischer Darstellung einen Ausschnitt aus einem belichteten und entwickelten Glasmaster des CD-Typs. Mit G ist der Glasträger bezeichnet, während P die Photolackschicht, das sog. Photoresist, bedeutet. Des weiteren sind die wichtigsten geometrischen Abmessungen angegeben.

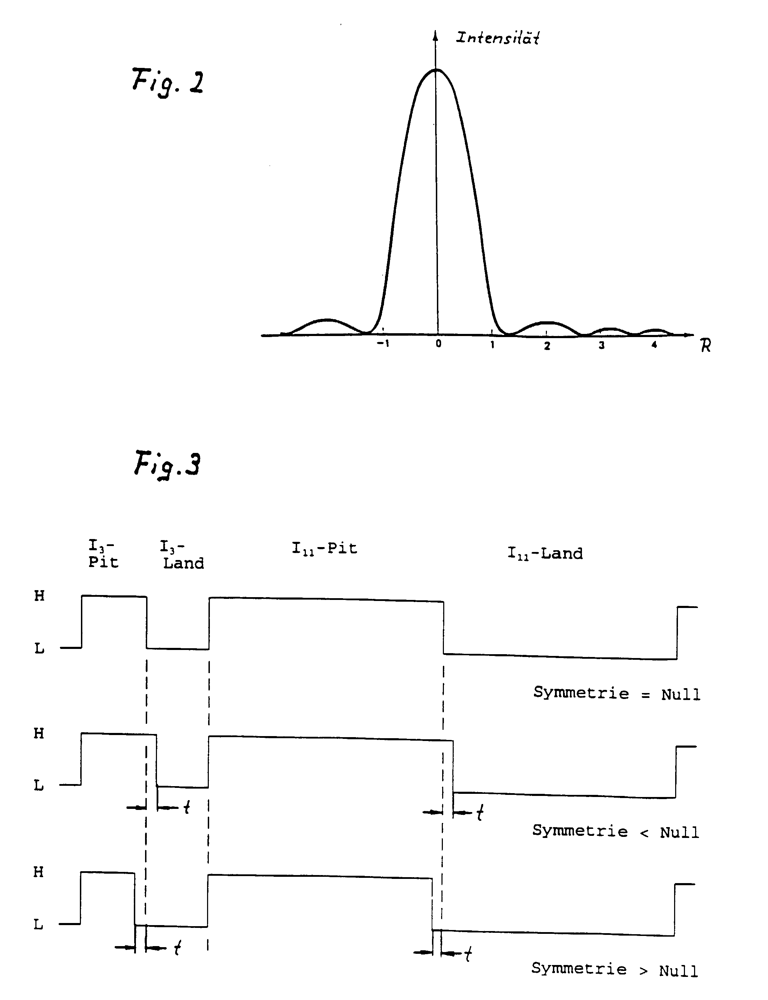

Figur 2 zeigt das Intensitätsprofil des zur Belichtung des Glasmasters nach Fig. 1 verwendeten Laserstrahls des Laserbeamrecorders. Dieses der Funktion sin x/x folgende Intensitätsprofil ist u. a. der Grund dafür, daß die Länge, die Breite und die Flankensteilheit der Pits mit zunehmender Entwicklungszeit größer werden.

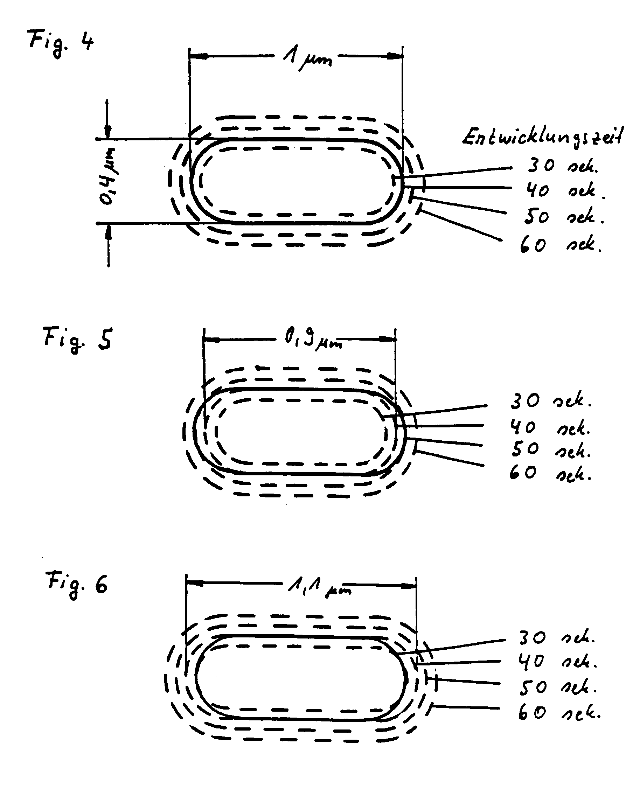

Figur 3 zeigt untereinander drei Zeitdiagramme eines den Laserbeamrecorder steuernden MTF-Signals zum Belichten des Glasmasters mit der Aufeinanderfolge eines I3-Pit, eines I3-Land, eines I11-Pit und eines I11-Land. Das oberste Diagramm gibt das bei dem bisher üblichen Verfahren verwendete MTF-Signal wieder, das, wechselstrommäßig betrachtet, gleichwertfrei ist. Das mittlere Diagramm zeigt den Fall der sog. negativen Symmetrie, bei dem die Dauer der die Pits schreibenden Impulse um ein konstantes Zeitintervall t verlängert und die den Lands entsprechenden Impulspausen um das gleiche Zeitintervall verkürzt sind. Das dritte Diagramm zeigt den umgekehrten Fall der sogenannten positiven Symmetrie.

Die Figuren 4, 5 und 6 veranschaulichen schematisch und etwa im Maßstab 1:50 000 vergrößert Aufsichten auf ein Pit mit den in der durchgezogenen Linie dargestellten Standardmaßen einer Länge von 1 µm und einer Breite von 0,4 µm. Die gestrichelt dargestellten Konturen zeigen die Umrisse von Pits, die sich bei den auf die entsprechenden Konturen bezogenen, kürzeren oder längeren Entwicklungszeiten als derjenigen ergeben würden, die der jeweiligen durchgezogenen Linie zugeordnet ist.

Für das nach dem herkömmlichen Verfahren erzeugte Pit nach Fig. 4 gilt für die Bedingung Symmetrie = 0 der aus der nachfolgenden Tabelle ersichtliche Zusammenhang:

| Belichtung | Entwickl. normal 40 sec. | Unterentw. 30 sec. | Überentw. 50 sec. | Überentw.ca. 60 sec |
|---|---|---|---|---|
| Pitlänge 1 µm | 1 µm | 0,9 µm | 1,1 µm | 1,2 µm |
| Pitbreite 0,4 µm | 0,4 µm | 0,3 µm | 0,5 µm | 0,6 µm |

Für den Figur 5 dargestellten Fall eines mit einem MTF-Signal mit positiver Symmetrie geschriebenen Pits gilt der in der nachfolgenden Tabelle angegebene Zusammenhang:

| Belichtung | Entwickl. normal 40 sec. | Unterentw. 30 sec. | Überentw. 50 sec. | Überentw. 60 sec. |
|---|---|---|---|---|
| Pitlänge 0,9 µm | 0,9 µm | 0,8 µm | 1 µm | 1,1 µm |
| Pitbreite 0,4 µm | 0,4 µm | 0,3 µm | 0,5 µm | 0,6 µm |

Für den in Figur 6 dargestellten Fall eines mit einem MTF-Signal mit negativer Symmetrie geschriebenen Pits gilt der in der nachfolgenden Tabelle dargestellte Zusammenhang:

| Belichtung | Entwickl. normal 40 sec. | Unterentw. 30 sec. | Überentw. 50 sec. | Überentw. 60sec. |
|---|---|---|---|---|
| Pitlänge 1,1 µm | 1,1 µm | 1 µm | 1,2 µm | 1,3 µm |
| Pitbreite 0,4 µm | 0,4 µm | 0,3 µm | 0,5 µm | 0,6 µm |

Wie der Vergleich der Figuren 4 bis 6 und der zugehörigen Tabellen verdeutlicht, können nach dem Verfahren nach der Erfindung Pits mit einer vorgegebenen, nämlich der zur Einhaltung der Bedingung Symmetrie = 0 auf dem replizierten Speichermedium erforderlichen Länge durch Veränderung der Symmetrie des den Laserbeamrecorder steuernden MTF-Signals mit unterschiedlicher Breite erzeugt werden. Zeichnerisch nicht wiedergegeben ist die Flankensteilheit, die jedoch näherungsweise proportional mit der Breite wächst.

In den Figuren 4 bis 6 ist die Abhängigkeit der Pitabmessungen von der Entwicklungszeit vereinfacht als linear wiedergegeben. Tatsächlich besteht jedoch, wie bekannt, ein nichtlinearer Zusammenhang.

## Patentansprüche

1. Verfahren zum Herstellen eines für die Replizierung von optischen Speichermedien des CD-Typs verwendbaren, einen planen Träger und eine Photolackschicht umfassenden Masters, in dessen Photolackschicht spurenweise angeordnete Vertiefungen, die sogenannten Pits, erzeugt werden, deren in Spurrichtung gemessene Länge und deren gegenseitiger Abstand, die sogenannten Lands, binär kodierte Daten repräsentieren, mit folgenden Verfahrensschritten:
1.1) Spurenweises Belichten der Photolackschicht mit einem Laserstrahl, der durch die H-Pegel eines Steuersignals ein- und durch dessen L-Pegel ausgeschaltet wird, wobei das Steuersignal das elektrische Abbild eines die zu speichernden Daten beinhaltenden, seriellen, binären Datenstroms ist,
1.2) Entwickeln des Trägers, bis die Photolackschicht an den belichteten Stellen Vertiefungen aufweist,
1.3) Beenden des Entwickelns, sobald die den H-Pegeln des Steuersignals entsprechenden Vertiefungen ein gemitteltes Volumen erreicht haben, das gleich einem vorgegebenen Wert ist,
dadurch gekennzeichnet,
1.4) daß das Verhältnis V der Dauer der H-Pegel zu der Dauer der L-Pegel des Steuersignals zumindest zeitweise von dem Wert 1,0 verschieden gemacht wird.

2. Verfahren nach Anspruch 1, dadurch gekennzeichnet, daß das Verhältnis V in einem Bereich liegt, dessen unterer Grenzwert einer Verkürzung der Dauer aller H-Pegel um die Dauer des die kürzesten Pits erzeugenden H-Pegels entspricht und dessen oberer Grenzwert einer Verlängerung der Dauer aller H-Pegel um die gleiche Dauer entspricht.

3. Verfahren nach einem der Ansprüche 1 oder 2, dadurch gekennzeichnet, daß das Verhältnis V während des Belichtens des Photolackschicht entsprechend den Abtastwerten eines Informationssignals geändert wird.

4. Verfahren nach Anspruch 3, dadurch gekennzeichnet, daß das Informationssignal ein binär kodiertes Signal ist.

5. Verfahren nach Anspruch 1, wobei die mittlere Länge der Vertiefungen in dem replizierten Speichermedium gleich der mittleren Länge deren gegenseitiger Abstände ist, dadurch gekennzeichnet, daß das Verhältnis V der Dauer der H-Pegel zu der Dauer der L-Pegel des Steuersignals kleiner als 1,0 gemacht wird und daß die Entwicklungszeit um einen solchen Betrag verlängert wird, daß die mittlere Länge der Vertiefungen in dem replizierten Speichermedium wieder gleich der mittleren Länge deren gegenseitiger Abstände ist.

6. Verfahren nach Anspruch 5, dadurch gekennzeichnet, daß die numerische Apertur des Laserstrahls auf einen Wert vergrößert wird, bei dem die Breite der Pits einen vorgegebenen Sollwert nicht überschreitet.

7. Verfahren nach Anspruch 1, wobei die mittlere Länge der Vertiefungen in dem replizierten Speichermedium gleich der mittleren Länge deren gegenseitiger Abstände ist, dadurch gekennzeichnet, daß das Verhältnis V der Dauer der H-Pegel zu der Dauer der L-Pegel des Steuersignals größer als 1,0 gemacht wird, und daß die Entwicklungszeit um einen solchen Betrag verkürzt wird, daß die mittlere Länge der Vertiefungen in dem replizierten Speichermedium wieder gleich der mittleren Länge deren gegenseitiger Abstände ist.

8. Verfahren nach Anspruch 7, dadurch gekennzeichnet, daß die numerische Apertur des Laserstrahls auf einen Wert verkleinert wird, bei dem die Pitbreite einen vorgegebenen Sollwert nicht unterschreitet.

## Claims

1. A process for producing a master which can be used for the replication of optical storage media of the CD-type and which includes a flat carrier and a photosensitive lacquer layer and in the photosensitive lacquer layer of which are produced depressions arranged in a track-wise manner, the so-called pits, whose length as measured in the track direction and whose mutual spacing, the so-called lands, represent binary coded data, comprising the following process steps:
1.1) track-wise exposure of the photosensitive lacquer layer with a laser beam which is switched on by the H-levels of a control signal and off by the L-levels thereof, wherein the control signal is the electrical image of a serial binary data stream containing the data to be stored,
1.2) development of the carrier until the photosensitive lacquer layer has depressions at the exposed locations, and
1.3) termination of the development step as soon as the depressions corresponding to the H-levels of the control signal have reached an averaged volume which is equal to a predetermined value,
characterised in that
1.4) the ratio V of the duration of the H-levels to the duration of the L-levels of the control signal is at least at times made different from the value 1.0.

2. A process according to claim 1 characterised in that the ratio V is in a range whose lower limit value corresponds to a reduction in the duration of all H-levels by the duration of the H-level producing the shortest pits and whose upper limit value corresponds to an increase in the duration of all H-levels by the same duration.

3. A process according to one of claims 1 and 2 characterised in that the ratio V is altered during the step of exposing the photosensitive lacquer layer in accordance with the sampling values of an information signal.

4. A process according to claim 3 characterised in that the information signal is a binary coded signal.

5. A process according to claim 1 wherein the mean length of the depressions in the replicated storage medium is equal to the mean length of the mutual spacings thereof, characterised in that the ratio V of the duration of the H-levels to the duration of the L-levels of the control signal is made less than 1.0 and that the development time is extended by such an amount that the mean length of the depressions in the replicated storage medium is again equal to the mean length of the mutual spacings thereof.

6. A process according to claim 5 characterised in that the numerical aperture of the laser beam is increased to a value at which the width of the pits does not exceed a predetermined reference value.

7. A process according to claim 1 wherein the mean length of the depressions in the replicated storage medium is equal to the mean length of the mutual spacings thereof, characterised in that the ratio V of the duration of the H-levels to the duration of the L-levels of the control signal is made greater than 1.0 and that the development time is reduced by such an amount that the mean length of the depressions in the replicated storage medium is again equal to the mean length of the mutual spacings thereof.

8. A process according to claim 7 characterised in that the numerical aperture of the laser beam is reduced to a value at which the pit width does not fall below a predetermined reference value.

## Revendications

1. Procédé pour produire un original comprenant un support plan et une couche de laque photosensible, pouvant être utilisé pour la reproduction de milieux de mémoire optiques du type CD, dans la couche photosensible duquel on produit des creux répartis sur des pistes, ce qu'on appelle les « pits » ou alvéoles, dont la longueur mesurée selon la direction des pistes et leurs espacements, ce qu'on appelle les plateaux, représentent des données codées en binaire, comprenant les phases de procédé suivantes :
1.1) on éclaire la couche de laque photosensible piste par piste avec un rayon laser qui est activé par les niveaux H d'un signal de commande et désactivé par les niveaux L de ce signal, le signal de commande étant l'image électrique d'un flux de données binaire, série, qui renferme des données à mémoriser,
1.2) on développe le support jusqu'à ce que la couche de laque photosensible présente des creux aux endroits éclairés,
1.3) on interrompt le développement dès que les creux correspondant aux niveaux H du signal de commande ont atteint un volume moyen qui est égal à une valeur prédéterminée,
caractérisé
1.4) en ce que le rapport V liant la durée des niveaux H à la durée des niveaux L du signal de commande est rendu, au moins temporairement, différent de la valeur 1,0.

2. Procédé selon la revendication 1, caractérisé en ce que le rapport V se trouve dans un intervalle dont la valeur limite inférieure correspond à un raccourcissement de la durée de tous les niveaux H de la valeur de la durée du niveau H qui produit les alvéoles les plus courts, et dont la valeur limite supérieure correspond à un allongement de même valeur de la durée de tous les niveaux H.

3. Procédé selon une des revendications 1 et 2, caractérisé en ce qu'au cours de l'éclairage de la couche de laque photosensible, on fait varier le rapport V en fonction des valeurs lues d'un signal d'information.

4. Procédé selon la revendication 3, caractérisé en ce que le signal d'information est un signal codé en binaire.

5. Procédé selon la revendication 1, dans lequel la longueur moyenne des creux formés dans le milieu de mémoire reproduit est égale à la longueur moyenne de leurs espacements, caractérisé en ce que le rapport V liant la durée des niveaux H à la durée des niveaux L du signal de commande est choisi inférieur à 1,0 et en ce que le temps de développement est prolongé d'une valeur telle que la longueur moyenne des creux formés dans le milieu de mémoire reproduit soit de nouveau égale à la longueur moyenne de leurs espacements.

6. Procédé selon la revendication 5, caractérisé en ce que l'ouverture numérique du rayon laser est agrandie à une valeur à laquelle la largeur des alvéoles n'excède pas une valeur de consigne prédéterminée.

7. Procédé selon la revendication 1, dans lequel la longueur moyenne des creux formés dans le milieu de mémoire reproduit est égale à la longueur moyenne de leurs espacements, caractérisé en ce que le rapport V liant la durée des niveaux H à la durée des niveaux L du signal de commande est choisi supérieur à 1,0 et en ce que le temps de développement est raccourci d'une valeur telle que la longueur moyenne des creux formés dans le milieu de mémoire reproduit soit de nouveau égale à la longueur moyenne de leurs espacements.

8. Procédé selon la revendication 7, caractérisé en ce que l'ouverture numérique du rayon laser est réduite à une valeur à laquelle la largeur des alvéoles ne devient pas inférieure à une valeur de consigne prédéterminée.
